# EUROPEAN PATENT APPLICATION

(11) **EP 3 236 484 A1**
(43) Date of publication of application: **25.10.2017**
(21) Application number: 17166352.9
(22) Date of filing: 12.04.2017
(51) Int. Cl.: H01H 31/00

(54) **EQUIPOTENTIAL SYSTEM FOR HVDC CONVERTER**

(30) Priority: 14.04.2016 GB 201606522
(71) Applicant: General Electric Technology GmbH, 5400 Baden (CH)
(72) Inventor: GREGOIRE, Jerome, Birmingham, West Midlands B1 2LS (GB)
(74) Representative: Cleary, Fidelma

(57) **Abstract**

A high voltage converter, comprises a plurality of modules (18a-c) and a plurality of mechanical switches (24, 26). Each switch is connected between two of the modules (18a-c) to switchably make an electrical connection between the two of said modules (18a-c). A first additional mechanical switch (28a) is provided, connected to one of said modules (18a) to switchably make an electrical connection between said module (18a) and an earth point.

## Description

This application relates to methods and apparatus for earthing high voltage power converters and in particular to methods and apparatus for earthing modules of a voltage source converter.

HVDC (high-voltage direct current) electrical power transmission uses direct current for the transmission of electrical power. This is an alternative to the more common alternating current electrical power transmission. There are a number of benefits to using HVDC electrical power transmission.

In order to use HVDC electrical power transmission, it is typically necessary to convert alternating current (AC) electrical power to direct current (DC) and back again. Recent developments in the power electronics field have led to an increased use of voltage-source converters (VSCs) for AC-DC and DC-AC conversion. VSCs make use of switching elements, typically insulated gate bipolar transistors (IGBTs) connected with respective anti-parallel diodes, that can be controllably turned on and off.

Various designs of VSC are known. Some types of VSC, such as the modular multilevel converter (MMC) or alternate arm converter (AAC) for example, make use of a series connection of a plurality of cells, each cell having an energy storage element such as a capacitor that can be selectively connected in series between the terminals of the cell or bypassed. The series connection of such cells is sometimes referred to as a chain-link circuit or chain-link converter or simply a chain-link and the cells are often referred to as sub-modules (with a plurality of cells forming a valve module).

In order to safely carry out maintenance in a high-voltage area, it is usually necessary to de-energize of all the converter parts, for example by connecting them to an electrical earth. In an HVDC valve hall that contains an HVDC converter, it is easy to earth the main AC and DC lines. However, HVDC converters such as voltage-source converters are very large and typically include hundreds of sub-module units, which have no direct electrical connection to earth. There are many different failure mechanisms that can affect the power block of a unit, such as the energy store discharge being incomplete, or semiconductors failing either short-circuit or open-circuit, and these can result in hazardous voltages appearing on the outer accessible sub-module connections.

It is therefore often mandatory to earth the accessible connections located on each of the units, as otherwise it is practically impossible for a person to approach the converter safely.

In some systems, groups of sub-modules are housed in modules, around each of which are arranged corona shields, each referenced to an electrical potential of one, or more than one, of the enclosed sub-modules. These corona shields are the nearest potentially-hazardous electrical conductors to an approaching maintainer and access vehicle.

One possibility is for the person carrying out maintenance to perform a manual earthing of each corona shield, one by one. For example, this can be achieved using cables that are linked to earth, held by long high-voltage-insulated spears. This typically requires a minimum of 2 people, and takes several hours to earth every corona shield.

WO2015/067296 discloses a system in which an extendable and retractable grounding device can be lowered into contact with all exposed conductive parts, and then raised when out of use. However, it is difficult to engineer such a system to be sure that the grounding device touches all of the parts that might be at high voltages.

Embodiments of the invention relate to methods and apparatus for earthing modules of a voltage source converter that at least mitigate at least some of the above mentioned issues.

Thus according to an aspect of the present invention there is provided a high voltage converter, comprising: a plurality of modules; a plurality of mechanical switches, each of said switches being connected between two of said modules to switchably make an electrical connection between the two of said modules; and a first additional mechanical switch, connected to one of said modules to switchably make an electrical connection between said module and an earth point.

Each module may have at least one corona shield associated therewith, wherein each of said mechanical switches is connected between two of said corona shields to switchably make an electrical connection between the two of said corona shields; and wherein the additional mechanical switch is connected to one of said corona shields to switchably make an electrical connection between said corona shield and an earth point.

Each module may be provided with at least one external electrode, wherein each of said mechanical switches is connected between two of said external electrodes to switchably make an electrical connection between the two of said modules or electrodes; and wherein the additional mechanical switch is connected to one of said external electrodes to switchably make an electrical connection between said module and an earth point.

The high voltage converter may further comprise a second additional mechanical switch, connected to another of said modules to switchably make an electrical connection between said module and an earth point.

The mechanical switches may be operable remotely.

The mechanical switches may be powered by pressure of a fluid, and the fluid may be an electrically non-conductive fluid.

The high voltage converter may comprise a pipe network for directing said fluid to the mechanical switches. In that case, the pipe network may be provided as a separate network from a cooling system providing fluid as a coolant for the modules, or the pipe network may be fluidly connected to a cooling system to provide said fluid as a coolant for the modules.

Each mechanical switch of said plurality of mechanical switches may comprise a discharge resistor, such that actuation of the switch first makes the electrical connection between the two of said modules through said discharge resistor and thereafter makes a direct electrical connection between the two of said modules.

Certain embodiments therefore may have some advantages such as reducing the earthing time by avoiding manual operations while being simple to engineer.

The invention will now be described by way of example only with reference to the accompanying figures, of which:
Figure 1 illustrates a system in accordance with one embodiment;
Figures 2(a) and 2(b) illustrate in more detail a first switch in the system of Figure 1;
Figures 3(a), 3(b) and 3(c) illustrate in more detail a second switch in the system of Figure 1;
Figures 4(a) and 4(b) illustrate in more detail a third switch in the system of Figure 1; and
Figures 5(a), 5(b) and 5(c) illustrate in more detail a fourth switch in the system of Figure 1.

Embodiments of the present invention relate to a high voltage converter, provided with a mechanism for earthing modules of the converter.

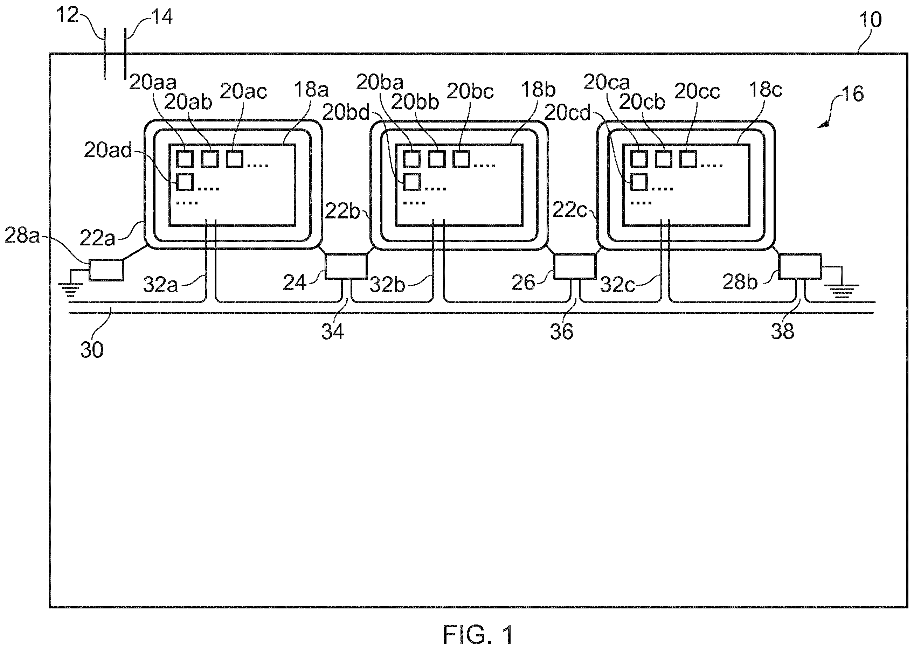

Figure 1 illustrates a HVDC (high-voltage direct current) valve hall 10. Figure 1 shows a high voltage DC line 12 and a high voltage AC line 14 entering and leaving the valve hall 10.

Figure 1 also shows a part of a high voltage converter 16 located in the valve hall 10. Specifically, Figure 1 shows three units, or modules 18a, 18b, 18c, although it will be appreciated that a high voltage converter 16 will typically include many more than three such modules. The modules will typically be located significantly above the floor of the valve hall 10, for example at heights of at least 3metres above ground level.

The module 18a includes a number of cells, or sub-modules 20aa, 20ab, 20ac, 20ad, .... Similarly, the module 18b includes a number of cells, or sub-modules 20ba, 20bb, 20bc, 20bd, ..., and the module 18c includes a number of cells, or sub-modules 20ca, 20cb, 20cc, 20cd, .... It will be appreciated that a module will typically include many more than fur such sub-modules.

Around each of the modules 18a, 18b, 18c is arranged at least one respective corona shield 22a, 22b, 22c. The corona shields are referenced to the electrical potential of one of the sub-modules enclosed in the respective module, and are provided to make the electric field distribution more uniform in the region around the respective module, in order to allow the modules to be closer together, without causing a risk of discharge or flashover between modules. The effect is that the corona shields are the nearest potentially-hazardous electrical conductors to a maintenance person and access vehicle.

Figure 1 also shows a mechanical switch 24 connected between the corona shields 22a and 22b, and a mechanical switch 26 connected between the corona shields 22b and 22c. Where the converter 16 has more than three corona shields, there may be more than two such switches, for example such that each of the corona shields is connected to at least one other corona shield. Figure 1 also shows a first additional mechanical switch 28a making an electrical connection between the corona shield 22a and earth, and a second additional mechanical switch 28b making an electrical connection between the corona shield 22c and earth.

Where the converter 16 has modules that are arranged in multiple rows, then, in each of the rows, mechanical switches may be provided to make connections between all of the corona shields associated with the modules in that row, with the additional mechanical switches 28a, 28b making an electrical connection between the corona shields in that row and earth. In some embodiments, a row is a series of chain linked sub modules that are placed at the same level (that is, at the same height above the ground).

Thus, closing the switches can bring all of the interconnected corona shields to the same potential, and closing the additional mechanical switch can bring the interconnected corona shields to earth potential.

As illustrated in this example, the mechanical switches interconnect corona shields that surround the respective modules. However, in other examples, the mechanical switches can interconnect the modules by connecting to any suitable electrodes or terminals on the modules.

In the embodiment illustrated in Figure 1, the switches 28a, 28b are of the same design as the switches 24, 26. However, it will be appreciated that the switches may be of different designs. For example, the switches that interconnect the corona shields, such as the switches 24, 26, may be of the same design, while the switches that connect a group of interconnected corona shields to earth may also be of the same design, or may be of a different design to the switches that interconnect the corona shields.

In the embodiment illustrated in Figure 1, the switches 24, 26, 28a, 28b are mechanical switches that can be operated remotely. Specifically, in this embodiment, the switches 24, 26, 28a, 28b are powered by means of fluid pressure, although other methods for powering the switches could be used.

In the embodiment illustrated in Figure 1, the converter 16 is provided with a cooling system that includes a pipe network 30, with spurs 32a, 32b, 32c providing coolant to the modules 18a, 18b, 18c respectively. The pipe network 30 and the spurs 32a, 32b, 32c may usefully be electrically-insulating, for example made from cross-linked polyethylene (PEX).

In this illustrated embodiment, the fluid from the cooling system is also used to provide power to the mechanical switches 24, 26, 28. Thus, a spur 34 off the pipe 30 is connected to the switch 24, a spur 36 off the pipe 30 is connected to the switch 26, and a spur 38 off the pipe 30 is connected to the switch 28. In other embodiments, a separate fluid network can be provided, in order to supply fluid to the mechanical switches.

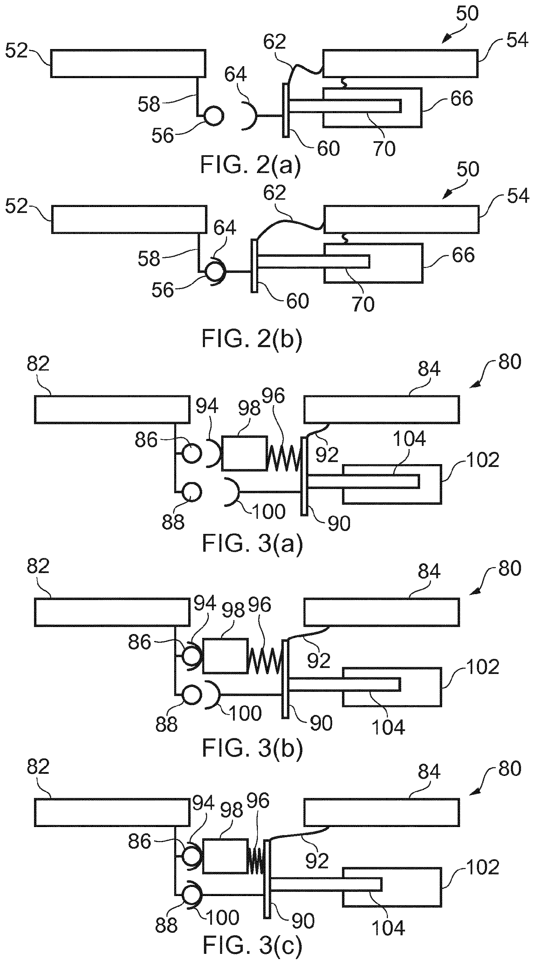

Figure 2 illustrates in more detail a first mechanical switch 50, which can be used as one or more of the switches 24, 26, 28a, 28b shown in Figure 1.

Specifically, Figure 2 shows a switch 50 that interconnects two electrodes 52, 54, which may be provided as external electrodes on the modules being interconnected, or may be provided on corona shields surrounding and forming part of the respective modules. A first terminal 56 of the switch 50 is connected to the first electrode 52 by an electrical connector 58, while a second terminal 60 of the switch 50 is connected to the second electrode 54 by an electrical connector 62.

The second terminal 60 has an extension 64 that is shaped to fit with the first terminal 56.

An actuator 66 is connected by to a fluid source. As described above, the fluid source may be the coolant network that is used to provide coolant to the modules. Alternatively, a separate fluid source can be provided, with suitable electrically-insulating pipes, made from a material such as cross-linked polyethene (PEX), containing an electrically insulating fluid such as air, oil, de-ionised water, or de-ionised water with added anti-freeze such as glycol, as examples. If a separate fluid source is provided, this allows the earthing operation to be carried out separately from controlling the cooling operation.

The actuator 66 includes a fixed part and a moving part 70, which can be moved in a controllable manner by modulating the pressure in the fluid system. The pressure of the fluid could act against a spring (not shown in Figure 2), such that the absence of pressure allows the switch to be returned to a particular position by the spring. The pressure of the fluid could be modulated either side of atmospheric pressure, in order to drive the switch both open and closed.

The moving part 70 of the actuator 66 is connected directly to the second terminal 60 of the switch 50.

Figure 2(a) shows the switch 50 in its open position, in which the two terminals 56, 60 are separated, and there is no electrical connection between the electrodes 52, 54.

Figure 2(b) shows the switch in a closed position, in which the moving part 70 of the actuator 66 has moved the terminal 60 slightly to the left as shown in Figure 2. In this position, the extension part 64 makes contact with the first terminal 56 of the switch 50. The extension part 64 and the first terminal 56 are shaped to minimise the resistance when they are brought into contact. Thus, the electrodes 52, 54 are brought to the same potential.

To open the switch again, the moving part 70 of the actuator 66 can move the terminal 60 back to the right, so that the extension part 64 no longer makes contact with the first terminal 56 of the switch 50.

Figure 3 illustrates in more detail a second mechanical switch 80, which can be used as one or more of the switches 24, 26, 28a, 28b shown in Figure 1.

Specifically, Figure 3 shows a switch 80 that interconnects two electrodes 82, 84, which may be provided on the modules being interconnected, or may be provided on corona shields surrounding the respective modules. First and second terminals 86, 88 of the switch 80 are connected to the first electrode 82, while a third terminal 90 of the switch 80 is connected to the second electrode 84 by an electrical connector 92.

The third terminal 90 has a first element 94 that is shaped to fit with the first terminal 86, and the first element 94 is connected to the body of the terminal 90 though a spring 96 and an electrical resistor 98. An additional wire could be provided between the resistor 98 and the third terminal 90, to avoid the need for electrical current to flow through the spring 96. The third terminal 90 also has a second element 100 that is shaped to fit with the second terminal 88.

An actuator 102 is connected by to a fluid source. As described above, the fluid source may be the coolant network that is used to provide coolant to the modules. Alternatively, a separate fluid source can be provided, with suitable electrically-insulating pipes, made from a material such as cross-linked polyethene (PEX), containing an electrically insulating fluid such as air, oil, de-ionised water, or de-ionised water with added anti-freeze such as glycol, as examples.

The actuator 102 includes a fixed part and a moving part 104, which can be moved in a controllable manner by modulating the pressure in the fluid system. The pressure of the fluid could act against a spring (not shown in Figure 3), such that the absence of pressure allows the switch to be returned to a particular position by the spring. The pressure of the fluid could be modulated either side of atmospheric pressure, in order to drive the switch both open and closed.

The moving part 104 of the actuator 102 is connected directly to the third terminal 90 of the switch 80.

Figure 3(a) shows the switch 80 in its open position, in which the first and second terminals 86, 88 are not in contact with the third terminal 90, and so there is no electrical connection between the electrodes 82, 84.

Figure 3(b) shows the switch in a partially closed position, in which the moving part 104 of the actuator 102 has moved the third terminal 90 slightly to the left as shown in Figure 3. In this position, the first element 94 makes contact with the first terminal 86 of the switch 80. The element 94 and the first terminal 86 are shaped to minimise the resistance when they are brought into contact. Thus, the electrodes 82, 84 are brought into electrical contact through the resistor 98, and so they are brought to similar potentials.

The resistor 98 may for example have a resistance in range of 0.1 - 10 ohms, and may be able to store energy in the range of 10kJ - 200kJ. Thus, for example, if one of the submodules in one of the modules is faulty, and its energy storage remains charged, the resistor 98 has the effect of limiting any discharge current.

Figure 3(c) shows the switch in a fully closed position, in which the moving part 104 of the actuator 102 has moved the third terminal 90 further to the left. In this position, the spring 96 accommodates the movement of the third terminal while the element 94 remains in the same place, and the second element 100 makes contact with the second terminal 88 of the switch 80. The element 100 and the second terminal 88 are shaped to minimise the resistance when they are brought into contact. Thus, the electrodes 82, 84 are brought into electrical contact through the second terminal 88 and the third terminal 90, short-circuiting the resistor 98, and so they are brought to the same potential.

To open the switch again, the moving part 104 of the actuator 102 can move the third terminal 90 back to the right, so that the electrical contact is broken.

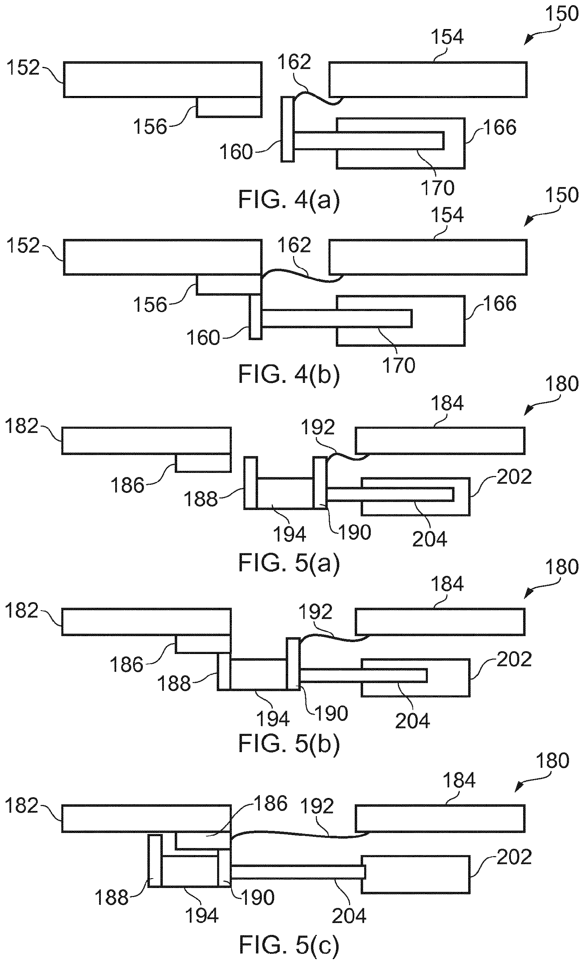

Figure 4 illustrates in more detail a third mechanical switch 150, which can be used as one or more of the switches 24, 26, 28a, 28b shown in Figure 1.

Specifically, Figure 4 shows a switch 150 that interconnects two electrodes 152, 154, which may be provided on the modules being interconnected, or may be provided on corona shields surrounding the respective modules. A first terminal 156 of the switch 150 is connected to the first electrode 152, while a second terminal 160 of the switch 150 is connected to the second electrode 154 by an electrical connector 162.

An actuator 166 is connected by to a fluid source. As described above, the fluid source may be the coolant network that is used to provide coolant to the modules. Alternatively, a separate fluid source can be provided, with suitable electrically-insulating pipes, made from a material such as cross-linked polyethene (PEX), containing an electrically insulating fluid such as air, oil, de-ionised water, or de-ionised water with added anti-freeze such as glycol, as examples.

The actuator 166 includes a fixed part and a moving part 170, which can be moved in a controllable manner by modulating the pressure in the fluid system. The pressure of the fluid could act against a spring (not shown in Figure 4), such that the absence of pressure allows the switch to be returned to a particular position by the spring. The pressure of the fluid could be modulated either side of atmospheric pressure, in order to drive the switch both open and closed.

The moving part 170 of the actuator 166 is connected directly to the second terminal 160 of the switch 150.

Figure 4(a) shows the switch 150 in its open position, in which the two terminals 156, 160 are separated, and there is no electrical connection between the electrodes 152, 154.

Figure 4(b) shows the switch in a closed position, in which the moving part 170 of the actuator 166 has moved the terminal 160 slightly to the left as shown in Figure 4. In this position, the second terminal 160 slides inside, and therefore makes electrical contact with, the first terminal 156 of the switch 150. Thus, the electrodes 152, 154 are brought to the same potential.

To open the switch again, the moving part 170 of the actuator 166 can move the terminal 160 back to the right, so that it no longer makes contact with the first terminal 156 of the switch 150.

Figure 5 illustrates in more detail a fourth mechanical switch 180, which can be used as one or more of the switches 24, 26, 28a, 28b shown in Figure 1.

Specifically, Figure 5 shows a switch 180 that interconnects two electrodes 182, 184, which may be provided on the modules being interconnected, or may be provided on corona shields surrounding the respective modules. A first terminal 186 of the switch 180 is connected to the first electrode 182, while second and third terminals 188, 190 of the switch 180 are connected to the second electrode 184 by an electrical connector 192.

The second and third terminals 188, 190 of the switch 180 are connected to each other through a resistor 194.

The second and third terminals 188, 190 are sliding terminals that are able to make electrical contact with the first terminal 186 by sliding inside it.

An actuator 202 is connected by to a fluid source. As described above, the fluid source may be the coolant network that is used to provide coolant to the modules. Alternatively, a separate fluid source can be provided, with suitable electrically-insulating pipes, made from a material such as cross-linked polyethene (PEX), containing an electrically insulating fluid such as air, oil, de-ionised water, or de-ionised water with added anti-freeze such as glycol, as examples.

The actuator 202 includes a fixed part and a moving part 204, which can be moved in a controllable manner by modulating the pressure in the fluid system. The pressure of the fluid could act against a spring (not shown in Figure 5), such that the absence of pressure allows the switch to be returned to a particular position by the spring. The pressure of the fluid could be modulated either side of atmospheric pressure, in order to drive the switch both open and closed.

The moving part 204 of the actuator 202 is connected directly to the second and third terminals 190 of the switch 180.

Figure 5(a) shows the switch 180 in its open position, in which the first terminal 186 is not in contact with either the second or third terminal 188, 190, and so there is no electrical connection between the electrodes 182, 184.

Figure 5(b) shows the switch in a partially closed position, in which the moving part 204 of the actuator 202 has moved the second and third terminals 188, 190 slightly to the left as shown in Figure 5. In this position, the second terminal 188 makes contact with the first terminal 186 of the switch 180. Thus, the electrodes 182, 184 are brought into electrical contact through the resistor 194, and so they are brought to similar potentials.

The resistor 194 may for example have a resistance in range of 0.1 - 10 ohms, and may be able to store energy in the range of 10kJ - 200kJ. Thus, for example, if one of the submodules in one of the modules is faulty, and its energy storage remains charged, the resistor 98 has the effect of limiting any discharge current.

Figure 5(c) shows the switch in a fully closed position, in which the moving part 204 of the actuator 202 has moved the second and third terminals 188, 190 further to the left. In this position, the third terminal 190 makes contact with the first terminal 186 of the switch 180. Thus, the electrodes 182, 184 are brought into electrical contact through the first terminal 186 and the third terminal 190, short-circuiting the resistor 194, and so they are brought to the same potential.

To open the switch again, the moving part 204 of the actuator 202 can move the second and third terminals 188, 190 back to the right, so that the electrical contact is broken.

The use of a fluid-powered actuator allows for the transfer of mechanical energy without resorting to electrical switching, using motors for example, which could cause problems in a high voltage environment.

Thus, closing the switches brings the electrodes, and hence the modules, to the same potential, and brings this equipotential to earth. All of the switches in one row of modules can be closed at the same time. In embodiments, the switches in the different rows may be closed at the same time, or at different times.

In some embodiments, a switch can be used to interconnect two modules, and a series of multiple switches can be used to interconnect a string of chain-link units. In other embodiments, a string of units may be interconnected through one switch.

The embodiments described above have described particular forms of mechanical switch, but other types of switch may be used. For example, switches with linear actuators have been described, but switches with rotary actuators could be used as one alternative.

Specific arrangements of corona shields, or electrodes, and switches have been described, but other arrangements of switches are also possible that can bring some of the modules in a converter to the same potential when the switches are closed.

As mentioned the embodiments relate to high voltage converters, such as VSCs, and it will be appreciated that these may be any type of high voltage converter, such as modular multilevel converter (MMC) type VSCs, alternate arm converter (AAC) type VSCs, line-commutated converter (LCC), Voltage Source Inverter (VSI), Load Commutated Inverter (LCI), Static VAR Compensators, Dynamic Static VAR Compensators (DSVCs), or Static Synchronous Compensator (STATCOM) devices.

It should be noted that the above-mentioned embodiments illustrate rather than limit the invention, and that those skilled in the art will be able to design many alternative embodiments without departing from the scope of the appended claims. The word "comprising" does not exclude the presence of elements or steps other than those listed in a claim, "a" or "an" does not exclude a plurality, and a single feature or other unit may fulfil the functions of several units recited in the claims. Any reference signs in the claims shall not be construed so as to limit their scope.

## Claims

1. A high voltage converter, comprising:
a plurality of modules (18a-c) located in a valve hall (10);
a plurality of mechanical switches (24, 26), each of said switches (24, 26) being connected between two of said modules (18a-c) to switchably make an electrical connection between the two of said modules (18a-c); and
a first additional mechanical switch (28a), connected to one of said modules (18a-c) to switchably make an electrical connection between said module (18a-c) and an earth point.

2. A high voltage converter as claimed in claim 1,
wherein each module (18a-c) has at least one corona shield (22a-c) associated therewith,
wherein each of said mechanical switches (24, 26) is connected between two of said corona shields (22a-c) to switchably make an electrical connection between the two of said corona shields (22a-c); and
wherein the additional mechanical switch (28a) is connected to one of said corona shields (22a-c) to switchably make an electrical connection between said corona shield (22a-c) and an earth point.

3. A high voltage converter as claimed in claim 1,
wherein each module (18a-c) is provided with at least one external electrode (52, 54),
wherein each of said mechanical switches (24, 26, 50) is connected between two of said external electrodes (52, 54) to switchably make an electrical connection between the two of said modules (18a-c) or electrodes (52, 54); and
wherein the additional mechanical switch (28a) is connected to one of said external electrodes (52, 54) to switchably make an electrical connection between said module (18a-c) and an earth point.

4. A high voltage converter as claimed in claim 1, 2 or 3, further comprising a second additional mechanical switch (80), connected to another of said modules (18a-c) to switchably make an electrical connection between said module (18a-c) and an earth point.

5. A high voltage converter as claimed in any preceding claim, wherein the mechanical switches (24, 26, 28a, 50, 80) can be operated remotely.

6. A high voltage converter as claimed in any preceding claim, wherein the mechanical switches of said plurality of mechanical switches (24, 26, 50, 80) are powered by pressure of a fluid.

7. A high voltage converter as claimed in claim 6, wherein the fluid is an electrically non-conductive fluid.

8. A high voltage converter as claimed in claim 6 or 7, comprising a pipe network (30) for directing said fluid to the mechanical switches (24, 26, 50, 80).

9. A high voltage converter as claimed in claim 8, wherein said pipe network (30) is provided as a separate network from a cooling system providing fluid as a coolant for the modules (18a-c).

10. A high voltage converter as claimed in claim 8, wherein said pipe network (30) is fluidly connected to a cooling system to provide said fluid as a coolant for the modules (18a-c).

11. A high voltage converter as claimed in any preceding claim, wherein each mechanical switch (24, 26, 50, 80) of said plurality of mechanical switches comprises a discharge resistor (98), such that actuation of the switch first makes the electrical connection between the two of said modules (18a-c) through said discharge resistor (98) and thereafter makes a direct electrical connection between the two of said modules (18a-c).
